# EUROPÄISCHE PATENTSCHRIFT

(11) **EP 1 162 647 B1**
(45) Veröffentlichungstag und Bekanntmachung des Hinweises auf die Patenterteilung: **28.02.2007**
(21) Anmeldenummer: 01112774.3
(22) Anmeldetag: 28.05.2001
(51) Int. Cl.: H01J 37/32

(54) **Plasma-Verdampfungsquelle mit Kathoden-Elektrode für eine Vakuum-Beschichtungsanordnung**
Plasma evaporation source with cathodic electrode for vacuum coating system
Source pour évaporation par plasma avec electrode cathodique pour un dispositif de dépot de couche

(30) Priorität: 08.06.2000 CH 11292000
(43) Veröffentlichungstag der Anmeldung: 12.12.2001
(73) Patentinhaber: Satis Vacuum Industries Vertriebs - AG, 6341 Baar/Zug (CH)
(72) Erfinder: Siegrist, Beat, 8704 Herrliberg (CH)
(74) Vertreter: Petschner, Goetz

(56) Entgegenhaltungen:
- EP-A- 0 529 268
- DE-A- 1 614 917
- DE-A- 19 804 838
- GB-A- 2 362 502
- US-A- 5 646 474
- US-A- 5 698 328
- US-A- 5 723 188
- HOFFMANN ET AL.: PHYS. REV. B, Bd. 30, Nr. 10, 1984, Seiten 6051-6056, XP002289314

## Beschreibung

Die vorliegende Erfindung betrifft eine Plasma-Verdampfungsquelle für eine Vakuum-Beschichtungsanordnung zum Aufbringen von Vergütungsschichten auf optische Substrate, mit einer mantelförmigen Anoden-Elektrode, einer äusseren Magnetspule und einer Kathoden-Elektrode.

Für das Aufbringen von Dünnschicht-Systemen auf optische Substrate, wie z. B. Brillengläser im Vakuum sind Plasma-Verdampfungsquellen zur Vorreinigung der Substrate und/oder Verbesserung der Schichteigenschaften, wie etwa Verdichtung der aufzudampfenden Schichten oder Erhöhung der Adhäsion bekannt. Eine Vakuum-Beschichtungsanordnung dieser Art ist beispielsweise im US-Patent 4 817 559 der gleichen Anmelderin beschrieben.

Die EP 0529268 beschreibt ein Verfahren zur Herstellung kratzfester Beschichtungen für optische Materialien aus Kunststoff. Die Schichten werden in einer Vakuumkammer aufgebracht, die einen Verdampfer und eine Plasmaquelle enthält. In der Plasmaquelle ist eine zylindrische, Elektronen emittierende LaB₆ - Kathode von einer zylindrischen Anode und einer äußeren Magnetspule umgeben.

Nachteilig bei diesen Verfahren ist, dass sich mit herkömmlichen Kathoden-Elektroden nur eine mässige Elektronenemission erreichen lässt. Zudem ist die Emission von Sekundär-Elektronen minimal. Infolge des lonenbeschusses errodiert die Kathode, welcher Abtrag besonders das Innere der Plasmaquelle beträchtlich verschmutzt. Durch den hohen Verschleiss der Kathode werden weiter die Lebensdauer der Kathode sowie die Plasmastabilität stark vermindert.

Herkömmliche Kathoden-Materialien gibt die US-A-5 723 188 an mit beispielsweise kubischem Bornitrid (cBN) bzw. cBN enthaltenden Schichten, welche Materialien geeignet sind, Schichten mit bestimmten Verschleisseigenschaften herzustellen, welche allerdings auch nicht geeignet sind, die vorgenannten Nachteile zu beheben.

Weiter beschreibt die US-A-5 646 474 eine Kathode aus Bornitrid (BN), wobei das BN von einer Schicht aus n-dotiertem Diamant unterlegt ist, um solche Kathoden insbesondere in der Verstärkertechnik, wie Mikroelektonik, als Niedertemperatur-Kathode im Bereich von extremen Minusgraden, etwa unter -40°C, einzusetzen. Eine solche Kathoden-Elektrode gibt ebenfalls keinen Hinweis auf Möglichkeiten, die vorgenannten Nachteile der bekannten Kathoden-Elektroden von Plasma-Verdampfungsquellen für eine Vakuum-Beschichtungsanordnung zum Aufbringen von Vergütungsschichten auf optische Substrate zu beheben.

Aufgabe der vorliegenden Erfindung ist nun eine wirksame Qualitätsverbesserung der Kathoden-Elektrode einer Plasma-Verdampfungsquelle für eine Vakuum-Beschichtungsanordnung zum Aufbringen von Vergütungsschichten auf optische Substrate, mit einer mantelförmigen Anoden-Elektrode, einer äusseren Magnetspule und einer Kathoden-Elektrode und damit auch eine wirksame Qualitätsverbesserung der Plasma-Verdampfungsquelle.

Dies wird erfindungsgemäss zunächst dadurch erreicht, dass die Kathoden-Elektrode mindestens teilweise aus dotiertem Diamant besteht.

Dem liegt nach der Festkörperphysik die Theorie zugrunde, dass in einem kristallinen Festkörper die Elektronenzustände mit dem sogenannten Bändermodell definiert werden, wonach die Elektronen insbesondere in den äusseren Körperbereichen zu quasikontinuierlichen (erlaubten) Bändern mit relativ hoher elektrischer Leitfähigkeit zusammengefasst sind, wobei der Bereich zwischen zwei erlaubten Bändern, welche hier die Aufenthaltszonen der zu emittierenden Elektronen sind, als verbotenes Band oder verbotener Energiebereich oder Bandlücke (gap) bezeichnet wird. Entsprechend ist dabei das wide band gap-Material der Kathoden-Elektrode in Form von dotiertem Diamant für eine optimale primäre und sekundäre Elektronenemission dotiert.

In diesem Zusammenhang sind unter primärer (Elektronen-) Emission, bzw. primären Elektronen die herkömmlich herangezogenen Verfahren zur Erzeugung von Elektronenemissionen aus Kathoden zu verstehen, also etwa durch Feldemission (Austritt von Elektronen aus der Kathode durch ein angelegtes elektrisches Feld); oder durch Glühemission (Aussendung von Elektronen durch Erhitzung der Kathode und dem daraus folgenden Austritt von Glühelektronen); oder durch thermische Emission (Elektronenemission aus erhitzter Kathode bei gleichzeitig angelegtem elektrischen Feld).

Ferner ist unter sekundärer (Elektronen-) Emission, bzw. Sekundärelektronen jener Elektronenaustritt aus der Kathoden-Oberfläche gemeint, welcher durch Teilchenbeschuss auf die Kathode aus dieser ausgelöst werden; hier durch den lonenbeschuss aus dem Plasma.

Es wurde nun gefunden, dass mit zunehmender Bandlücke zwischen zwei erlaubten Bändern bei geeigneter Energiezufuhr eine wesentliche Erhöhung der Emission primärer und sekundärer Elektronen erfolgt, was erfindungsgemäss dadurch erreicht wird, dass die Kathoden-Elektrode mindestens teilweise aus dotiertem Diamant besteht.

Solche Elektroden können beispielsweise durch Gasphasenabscheidung (CVD-Prozess), Aufstäubung (Sputtering) oder mittels der Epitaxie-Technik hergestellt werden. Die Elektroden können direkt durch Gleichstrom oder induktive Hochfrequenz, als auch indirekt mittels Sekundärwiderstandsheizung (thermischem Strahler) beheizt werden. Die Elektronen emittieren dann von der Kathode thermoelektrisch mit einem geringen Anteil der Feldemission. Die Kathode kann aber auch verstärkt in Feldemission wirksam sein durch Anlegen einer genügend grossen Vorspannung zwischen Anode und Kathode. Im Gegensatz zu Kathoden aus einem Metalloxid erzeugt hier der lonenbeschuss die gewünschte erhöhte Emission von Sekundär-Elektronen.

Im Vergleich mit allen anderen Materialien sind die physikalischen Eigenschaften von Diamant in allen bekannten Wertungsbereichen überlegen, wie die nachfolgende Tabelle zeigt.

| Eigenschaft | Wert | Einheit |
|---|---|---|
| Dielectric Constant | 5.61 | |
| Dielectric Strength | 1.0X10 ⁷ | V/cm |
| Dielectric loss | 6.0X10 ⁻⁴ | Tangent |
| Refractive Index | 2.4 | |
| Bandgap | 5.45 | eV |
| Hole mobility | 1.6x10 ³ | cm² /V-sec |
| Hole velocity | 1.0X10 ⁷ | cm/sec |
| Electron mobility | 2.2X10 ³ | cm² /V-sec |
| Electron velocy | 2.2X10 ⁷ | cm/sec |
| Resistivity | 10X10 ¹³ | ohm-cm |
| Thermal Conductivity | 2000 | W/m-K |
| Thermal Expansion Coefficient | 1.1X10 ⁻⁶ | /K |
| Work Function (111) face | -4.5 | eV |
| Lattice Constant | 3.57 | Angstroms |

Das Diamant-Material der Kathode hat ein sehr hohes Emissionsvermögen sekundärer Elektronen im Vergleich zu herkömmlichen Kathodenmaterialien. Diamant ist chemisch sehr stabil. Dies vermindert die durch lonenbeschuss hervorgerufene Kathodenerrosion und dadurch die Verschmutzung der Plasma-Quelle. Der geringe Verschleiss der Kathode verbessert zudem wirksam deren Lebensdauer sowie die Stabilität des Plasmas. Ferner weist Diamant eine hohe thermische Leitfähigkeit auf, sodass die durch die indirekte oder direkte Heizung erzeugte Wärme schnell und gleichförmig die ganze Kathode erfasst.

Bei einer bevorzugten Ausführungsform kann das dotierte Diamant-Material mit Stickstoff (N) oder Schwefel (S) dotierter Diamant sein. Ferner kann die Kathoden-Elektrode eine metallische Unterbau-Struktur aufweisen mit einem Schichtüberzug aus dotiertem Diamant. Hierbei kann der metallische Unterbau aus Wolram (W) oder Molybdän (Mo) oder Tantal (Ta) besteht. Weiter kann die Kathoden-Elektrode eine zylindrische, kegelförmige, topfförmige, hauben- oder domförmige oder gitterförmige Ausgestaltung aufweisen.

Beispielsweise Ausführungsformen des Erfindungsgegenstandes sind nachfolgend anhand der Zeichnungen näher erläutert. Es zeigen:
- Fig. 1a und 1b: zwei unterschiedliche Ausführungsformen einer Plasma-Quelle für eine Vakuum-Beschichtungsanordnung zum Aufbringen von Vergütungsschichten auf optische Substrate;
- Fig. 2 bis 5: unterschiedliche Ausführungsformen einer Kathoden-Elektrode für eine Plasma-Quelle gemäss Fig. 1
- Fig. 6: und eine Homogenisierungsanordnung der Plasma-Quelle gemäss Fig. 1.

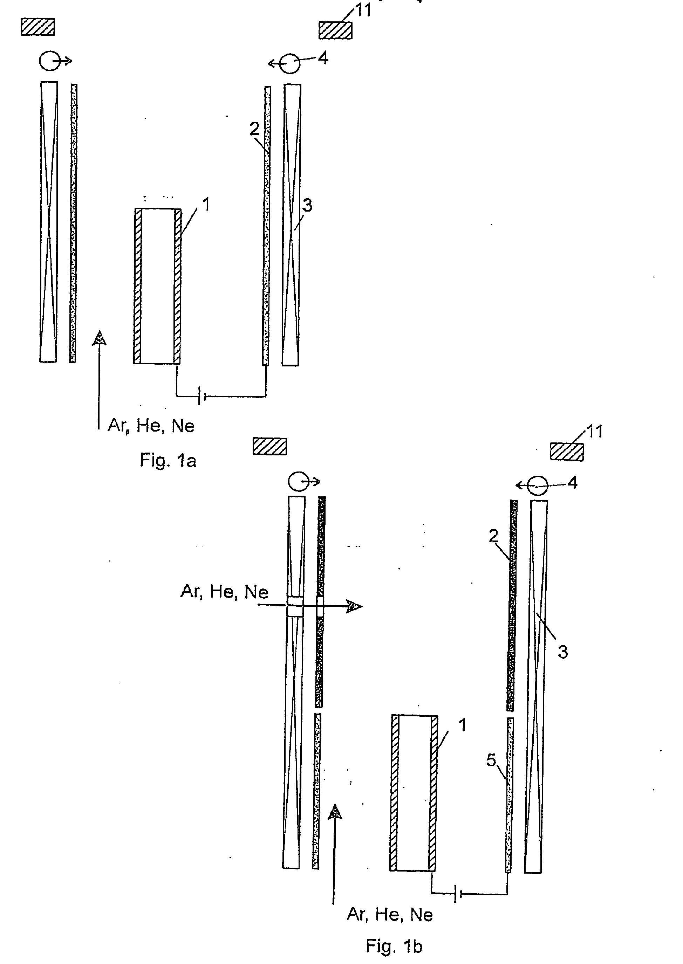

In Fig. 1a und 1b sind zwei unterschiedliche Ausführungsformen einer Plasma-Quelle für eine Vakuum-Beschichtungsanordnung zum Aufbringen von Vergütungsschichten auf optische Substrate veranschaulicht, mit einer rohr- oder zylinderförmigen Anode 2 mit kreisförmigem Querschnitt, die eine innere Kathode 1 umgibt, sowie mit einer äusseren Magnetspule (Solenoid) 3.

Gemäss Fig. 1a umgibt die Anode 2 direkt die Kathode 1. Gemäss Fig. 1b hingegen ist die Kathode 1 von einem Isolationsmantel aus Quartz oder temperaturfestem Keramik 5 umgeben an dem die Anode 2 anschliesst.

Eine solche Plasma-Quelle ist in einem evakuierbaren Rezipienten (nicht gezeigt) angeordnet. Hierbei kann die Kathode direkt durch Gleichstrom oder induktiver Hochfrequenz, als auch indirekt mittels Sekundärwiderstandsheizung (Heizstrahler) beheizt werden. Die Elektronen emittieren dann von der Kathode, sobald diese einen Temperaturwert erreicht hat, dass die Elektronen die Energiedifferenz der Bänder des Kathodenmaterials überwinden.

Die Elektronen-Emission ist hauptsächlich thermoelektrisch mit geringem Anteil einer Feldelektronenemission. Die Kathode kann aber auch in Feldemission wirksam sein durch Anlegen einer genügend grossen Spannung zwischen Anode und Kathode sowie genügend niedrigem Druck in der Vakuumkammer (gutes Vakuum).

Das Entladungs-Gas oder -Gasgemisch zur Erzeugung des Plasmas im Rezipienten ist ein inertes Gas (Arbeitsgas), wie Argon (Ar), Neon (Ne), Helium (He) u.a. Hierbei sind Anode und Kathode mit einer Spannungsquelle zur Steuerung von Entladungsspannung und -strom des Plasmas verbunden.

Die Bauform der Anode 2 gemäss Fig. 1b ist hierbei derart modifiziert, dass der direkte Aufprall durch positiv geladene lonen auf die Kathode 1, welcher aus dem nahen Abstand zur positiv geladenen Anode resultiert, reduziert wird.

Die Magnetspule 3 wirkt auf die von der Kathode emittierten Elektronen effektiv ein und die ionisierten Entladungsgase, welche aufwärts weg von der Kathode strömen, tragen die Elektronen entlang einer spiralförmigen Bewegung mit. Ferner sind oberhalb der Anode 2 Einlässe 4 für ein reaktives Gas vorgesehen, beispielsweise Sauerstoff (O₂) oder Stickstoff (N₂), welches mit dem ionisierten Inert-Gas (Arbeitsgas) und den hochenergetischen Elektronen reagiert. Dieser starke lonenstrom kann verwendet werden zur Unterstützung und Qualitätsverbesserung (Verdichtung) der aufwachsenden Schichten während eines Vakuum-Beschichtungsprozesses. Hierbei kann eine magnetische Homogenisierungsanordnung 11 oberhalb des Plasma-Auslasses die Homogenität des Plasmas steigern.

Erfindungsgemäss besteht nun die Kathoden-Elektrode mindestens teilweise aus dotiertem Diamant mit besonders ausgeprägter primärer und sekundärer Elektronenemission.

Das Diamant-Material der Kathode hat ein hochgradiges Emissionsvermögen sekundärer Elektronen im Vergleich zu herkömmlichen Kathodenmaterialien. Dies bedeutet, dass der Kathodenfall der Entladung verringert wird, was den gesamten Leistungsbedarf der Anordnung vermindert. Zudem ist Diamant chemisch sehr stabil. Dies vermindert die Kathodenerrosion (Materialabtrag durch den lonenbeschuss) und dadurch die Verschmutzung von Plasma-Quelle, Entladungsraum und Rezipienten.

Der geringe Kathodenverschleiss verbessert zudem wirksam die Lebensdauer der Kathode und die Stabilität des Plasmas. Ferner weist Diamant eine hohe thermische Leitfähigkeit auf, sodass die durch die indirekte oder direkte Heizung erzeugte Wärme schnell und gleichförmig die ganze Kathode erfasst.

Auch die durch den lonenbeschuss entstehende Wärme wird gleichermassen rasch durch die ganze Kathode geleitet, was eine wesentlich erhöhte gleichförmige Elektonen-Emission über die ganze Kathodenoberfläche bewirkt.

Wie bereits erwähnt, ist ein bevorzugtes Material für die Kathode-Elektrode etwa mit Stickstoff (N) oder Schwefel (S) dotierter Diamant.

Hiebei kann die Kathode eine metallische Unterbau-Struktur aufweisen mit einem beispielsweise durch Gasphasenabscheidung (CVD-Prozess) oder Aufstäuben (Sputtering) oder mittels Epitaxie-Technik aufgebrachten Schichtüberzug aus dotiertem Diamant, wobei der metallische Unterbau vorzugsweise aus Wolram (W) oder Molybdän (Mo) oder Tantal (Ta) besteht.

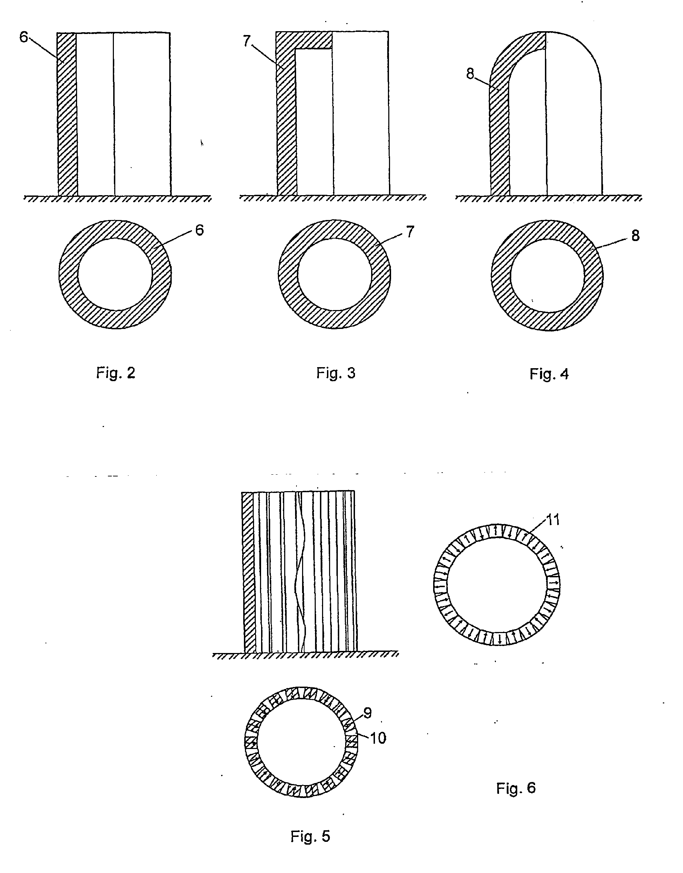

Die Kathoden-Elektrode kann gemäss den Fig. 2 bis 5 ferner von unterschiedlicher Konfiguration sein, nämlich gemäss Fig.2 ein zylinderförmiger Körper 6, gemäss Fig. 3 ein topfförmiger Körper 7, gemäss Fig. 4 ein domförmiger Körper 8 oder gemäss Fig. 5 ein aus Stäben 9 zusammengefügtes Gitter 10. Die Kathode ist dabei koaxial zur Anode angeordnet (Fig. 1a u. 1b). Dabei kann die Kathode, wie vorerwähnt, einen metallischen Unterbau aufweisen, beispielsweise in Form eines Rahmens aus spulenförmig gewundenem Draht u.a.

Ferner ist in Fig. 6 eine anhand von Fig. 1a/1b vorbeschriebene Homogenisierungsanordnung 11 näher dargestellt, welche sich zwischen Plasma-Quelle und zu beschichtenden Substraten (nicht gezeigt) befindet. Hierbei wird ein starkes Magnetfeld durch die Anordnung von Magneten in mehrfacher Polumkehrung erreicht, welches den Plasma-Strahl umhüllt. Hierbei kann beispielsweise mittels SmCo-Magneten bei einem Magnetfeld mit der Stärke von 410 mT und einer Elektronen-Teperatur von 1 eV eine lonen-Geschwindigkeit von 1 m/s drehend im Uhrzeigersinn zum Magnetfeld erzeugt werden.

Eine solche Anordnung kann beispielsweise 30 solcher SmCo-Magnete umfassen für eine Homogenisierungseinrichtung von ca. 22 cm Durchmesser.

Es wird Schutz beansprucht wie folgt:

## Patentansprüche

1. Plasma-Verdampfungsquelle für eine Vakuum-Beschichtungsanordnung zum Aufbringen von Vergütungsschichten auf optische Substrate, mit einer mantelförmigen Anoden-Elektrode (2), einer äusseren Magnetspule (3) und einer Kathoden-Elektrode (1), **dadurch gekennzeichnet,**
**dass** die Kathoden-Elektrode (1) mindestens teilweise aus dotiertem Diamant besteht.

2. Plasma-Verdampfungsquelle nach Anspruch 1, **dadurch gekennzeichnet, dass** das dotierte Diamant-Material mit Stickstoff (N) oder Schwefel (S) dotierter Diamant ist.

3. Plasma-Verdampfungsquelle nach Anspruch 1, **dadurch gekennzeichnet, dass** die Kathoden-Elektrode (1) eine metallische Unterbau-Struktur aufweist mit einem Schichtüberzug aus dotiertem Diamant.

4. Plasma-Verdampfungsquelle nach Anspruch 3, **dadurch gekennzeichnet, dass** der metallische Unterbau aus Wolfram (W) oder Molybdän (Mo) oder Tantal (Ta) besteht.

5. Plasma-Verdampfungsquelle nach Anspruch 3, **dadurch gekennzeichnet, dass** die Kathoden-Elektrode (1) eine zylindrische, kegelförmige, topfförmige, hauben- oder domförmige oder gitterförmige Ausgestaltung aufweist.

## Claims

1. Plasma evaporation source for a vacuum coating arrangement for application of refining coatings to optical substrates, with a sheath-shaped anode electrode (2), an outer magnet coil (3) and a cathode electrode (1), **characterised in that** the cathode electrode (1) consists at least partly of doped diamond.

2. Plasma evaporation source according to claim 1, **characterised in that** the doped diamond material is diamond doped with nitrogen (N) or sulphur (S).

3. Plasma evaporation source according to claim 1, **characterised in that** the cathode electrode (1) has a metallic substructure with a coating covering of doped diamond.

4. Plasma evaporation source according to claim 3, **characterised in that** the metal substructure consists of tungsten (W), molybdenum (Mo) or tantalum (Ta).

5. Plasma evaporation source according to claim 3, **characterised in that** the cathode electrode (1) has a cylindrical, conical, pot-shaped, hood-shaped, dome-shaped or grid-shaped form.

## Revendications

1. Source pour évaporation par plasma pour un dispositif de dépôt de couche sous vide pour le dépôt de couches antireflet sur des substrats optiques, avec une électrode anode (2) en forme d'enveloppe périphérique, une bobine magnétique extérieure (3) et une électrode cathode (1), **caractérisée en ce que**
l'électrode cathode (1) consiste au moins en partie en diamant dopé.

2. Source pour évaporation par plasma selon la revendication 1, **caractérisée en ce que** le matériau diamant dopé est un diamant dopé avec de l'azote (N) ou du soufre (S).

3. Source pour évaporation par plasma selon la revendication 1, **caractérisée en ce que** l'électrode cathode (1) comporte une sous-structure métallique avec un revêtement par une couche de diamant dopé.

4. Source pour évaporation par plasma selon la revendication 3, **caractérisée en ce que** la sous-structure métallique consiste en tungstène (W) ou en molybdène (Mo) ou en tantale (Ta).

5. Source pour évaporation par plasma selon la revendication 3, **caractérisée en ce que** l'électrode cathode (1) présente une configuration cylindrique, conique, en forme de pot, en forme de capot ou en forme de dôme, ou en forme de grille.
